# EUROPEAN PATENT SPECIFICATION

(11) **EP 0 336 036 B1**
(45) Date of publication and mention of the grant of the patent: **15.12.1993**
(21) Application number: 88308530.0
(22) Date of filing: 15.09.1988
(51) Int. Cl.: G01R 31/02

(54) **Cable failure detection system**
System zur Detektion von Fehlern in Kabeln
Système de détection de défauts dans un câble

(30) Priority: 30.03.1988 US 175251
(43) Date of publication of application: 11.10.1989
(73) Proprietor: Vokey, David E., Southbridge, MA 01550 (US); Sontag, Kenneth N., Winnipeg Manitoba R2C 2Z2 (CA)
(72) Inventor: Vokey, David E., Southbridge, MA 01550 (US); Sontag, Kenneth N., Winnipeg Manitoba R2C 2Z2 (CA)
(74) Representative: Frost, Dennis Thomas

(56) References cited:
- GB-A- 2 082 406
- US-A- 3 299 351
- US-A- 4 051 436

## Description

### FIELD OF THE INVENTION

The present invention relates to cable monitoring systems and methods and more particularly to cable monitoring systems for detecting moisture penetration into a communications cable.

### BACKGROUND

Water or moisture penetration into any outside cable plant can cause communications circuits to fail. Outages often occur at the most inopportune time and are costly to locate and repair. The presence of water in the cable may cause a variety of problems including the short circuiting of copper pairs and degradation of mechanical components of the cable. With fiber optic cable, freezing of penetrated water may cause rupture of the fibers and the water may attack and separate the fiber coatings. This may result in increased microbending and attenuation, stress, fatigue, and ultimate failure of the fibers.

A wide range of materials and methods have been employed with varying degrees of success, in an effort to maintain outside cable plants. These include pressurization, the use of double enclosures and encapsulation. All of these techniques are costly and do not provide for the detection of water entry.

In addition, pressurization is ineffective on fiber optic cables while double enclosures are bulky and capsulating materials are messy to handle.

US-A-4,480,251 describes an alternative system which monitors electrical cables for moisture penetration. In this system a moisture detecting tape including two isolated conductors is wrapped around the cable, end to end. At a remote end of the cable, the two conductors are connected through a resistance, while a DC signal is passed through the cable from the other end. The DC current is monitored to detect moisture penetration of the tape.

The present invention aims at an improved system of this type.

US-A-3299351 discloses - in the context of an apparatus for detecting faults in buried cables - the feature of applying a line signal to a metallic component integral with the cable, on the one hand, and to an earth return path, on the other hand.

### SUMMARY

According to the present invention there is provided a method of and an apparatus for monitoring a communications cable for moisture penetration as defined in Claims 1 and 3, respectively.

The line signal may be a DC signal maintaining the armour at a negative potential with respect to ground, providing the cable with anodic protection.

### BRIEF DESCRIPTION OF THE DRAWINGS

In the accompanying drawings, which illustrate exemplary embodiments of the present invention:
Figure 1 is a schematic illustration of a monitored trunk cable; and
Figure 2 is a schematic illustration of a moisture system using a steel armour and an earth return.

### DETAILED DESCRIPTION

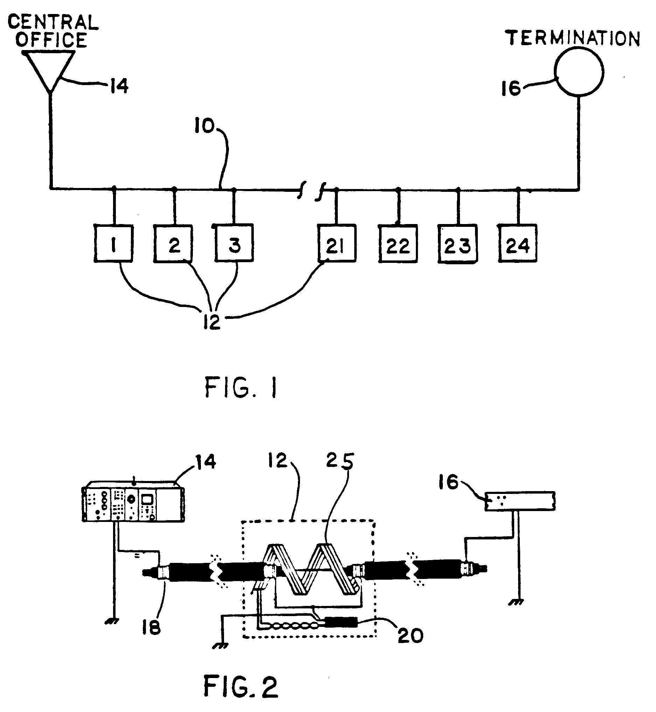

Referring to the accompanying drawings, Figure 1 illustrates a typical monitored trunk cable run. The illustrated cable 10 has twenty-four splices, each housed in a splice closure 12. The system is monitored from the central office unit 14 at one end of the line while a detection line termination 16 is found at the other end of the line. While not illustrated, the system may also be used to monitor feeder cables with branch cable runs. The detection lines for branch cables are half tapped into the main cable detection line at the splice points.

Figure 2 illustrates an embodiment of the present system using a cable armour layer 18 as the moisture detecting conductor. The armour layer 18 is connected to the central office unit 14 and the termination 16 at opposite ends of the cable.

A pre-determined "nominal" DC line current through the cable armour with a return path through the ground is continuously monitored by the central office unit 14. An operating window is established and line current deviation beyond the set limits results in specific alarm conditions. These include a line alarm that results if the detection line current drops below a set value, indicating that an "open" has occurred in the cable system. A cable alarm occurs if the detection line current increases beyond another set value and indicates that water has entered the cable.

In each splice enclosure 12, there is a remote sensor 20 connected to a moisture detection tape 25 that is wrapped around the splice bundle. When water contacts the tape, the remote sensor is triggered to transmit a 32-baud digitally encoded splice sensor unit (SSU) alarm signal to the office terminal through the armour 18. The terminal equipment 14 intercepts, decodes, and displays the exact location of the trouble.

The DC current supplied to the armour maintains the armour at a negative potential with respect to ground, so that the cable is anodically protected.

While one particular embodiment of the invention has been described in the foregoing, it is to be understood that other embodiments are possible within the scope of the invention, which should be ascertained solely by reference to the accompanying Claims.

## Claims

1. A method of monitoring a communications cable (10) having a core, and protective sheath surrounding the core, said method comprising generating a fixed voltage DC line signal, applying the line signal to the proximal end of an electric circuit consisting of a conductor (18) extending the length of the cable (10), a return path and terminating resistor means (16) electrically connecting the conductor (18) to the return path at the distal end of the electric circuit and monitoring changes in the line signal current, whereby increased line signal current indicates moisture penetration of the cable (10) to form a conductive path, characterised in that the conductor comprises a metallic armour layer (18) of the cable whereby decreased line signal current indicates increased armour layer resistance and thus damage to the armour layer (18) and the return path is a ground return path.

2. A method according to Claim 1 characterised by applying to the armour layer (18) of the cable (10) a DC signal with a negative potential with respect to ground.

3. A system for monitoring a communications cable having a core, a protective sheath surrounding the core, said system comprising a fixed voltage DC line signal generator for applying the line signal to the proximal end of an electric circuit comprising a conductor (18) extending the length of the cable (10) a return path and terminating resistor means (16) electrically connecting the conductor (18) to the return path at the distal end of the electric circuit to enable changes in the line signal current to be monitored whereby increased line signal current indicated moisture penetration of the cable (10) to form a conductive path, characterised in that the conductor comprises a metallic armour layer (18) of the cable whereby decreased line signal current is monitored to indicate increased armour layer resistance and thus damage to the armour layer, and the return path is a ground return path.

4. A system according to Claim 3 characterised in that the signal generating means comprise means for applying a direct current signal to the armour layer (18) of the cable (10), with a negative potential with respect to the ground.

## Patentansprüche

1. Verfahren zum Überwachen eines Übertragungskabels (10) mit einer Kabelseele und einem Schutzmantel, der die Kabelseele umgibt, welches Verfahren das Erzeugen eines Gleichstromleitungssignals mit fester Spannung, das Anlegen des Leitungssignals an das proximale Ende einer elektrischen Schaltung, die aus einem Leiter (18), der über die Länge des Kabels (10) verläuft, einem Rückstromweg und einer Stromleitungsendwiderstandseinrichtung (16) besteht, die elektrisch den Leiter (18) mit dem Rückstromweg am distalen Ende der elektrischen Schaltung verbindet, und das Überwachen von Änderungen im Leitungssignalstrom umfaßt, wobei ein zunehmender Leitungssignalstrom das Eindringen von Feuchtigkeit in das Kabel (10) anzeigt, so daß ein Leitungsweg gebildet wird, dadurch gekennzeichnet, daß der Leiter eine metallische Bewehrungsschicht (18) des Kabels umfaßt, so daß ein abnehmender Leitungssignalstrom einen zunehmenden Bewehrungsschichtwiderstand und somit eine Beschädigung der Bewehrungsschicht (18) anzeigt, und der Rückstromweg ein Masserückstromweg ist.

2. Verfahren nach Anspruch 1, dadurch gekennzeichnet, daß an die Bewehrungsschicht (18) des Kabels (10) ein Gleichspannungssignal mit einem bezüglich Masse negativen Potential gelegt wird.

3. Anordnung zum Überwachen eines Übertragungskabels mit einer Kabelseele, einem Schutzmantel, der die Kabelseele umgibt, welche Anordnung einen Generator für ein Gleichstromleitungssignal mit fester Spannung zum Anlegen des Leitungssignals an das proximale Ende einer elektrischen Schaltung umfaßt, die einen Leiter (18), der über die Länge des Kabels (10) verläuft, einen Rückstromweg und eine Stromleitungsendwiderstandseinrichtung (16) umfaßt, die elektrisch den Leiter (18) mit dem Rückstromweg am distalen Ende der elektrischen Schaltung verbindet, um Änderungen im Leitungssignalstrom überwachen zu können, wobei ein zunehmender Leitungssignalstrom das Eindringen von Feuchtigkeit in das Kabel (10) anzeigt, so daß ein Leitungsweg gebildet ist, dadurch gekennzeichnet, daß der Leiter eine metallische Bewehrungsschicht (18) des Kabels umfaßt, so daß ein abnehmender Leitungssignalstrom überwacht wird, um einen zunehmenden Bewehrungsschichtwiderstand und somit eine Beschädigung der Bewehrungsschicht anzuzeigen, und der Rückstromweg ein Masserückstromweg ist.

4. Anordnung nach Anspruch 3, dadurch gekennzeichnet, daß die Signalgeneratoreinrichtung eine Einrichtung zum Anlegen eines Gleichspannungssignals an die Bewehrungsschicht (18) des Kabels (10) mit einem bezüglich Masse negativen Potential umfaßt.

## Revendications

1. Procédé de contrôle d'un câble de communication (10) constitué d'un noyau et d'une gaine de protection entourant le noyau, le procédé comportant la génération d'un signal de ligne continu à tension fixe, l'application du signal de ligne à l'extrémité proximale d'un circuit électrique constitué d'un conducteur (18) s'étendant le long du câble (10), un chemin de retour et une résistance de terminaison (16) reliant électriquement le conducteur (18) au chemin de retour à l'extrémité distale du circuit électrique et contrôlant les changements dans le courant du signal de ligne, de sorte qu'un accroissement du courant du signal de ligne indique une pénétration d'humidité dans le câble (10) constituant un chemin conducteur, caractérisé en ce que le conducteur comporte une couche de blindage métallique (18) du câble, de sorte qu'une diminution du courant du signal de ligne indique un accroissement de la résistance de la couche de blindage et par conséquent un endommagement de la couche de blindage (18), et en ce que le chemin de retour est un chemin de retour par le sol.

2. Procédé selon la revendication 1, caractérisé par l'application à la couche de blindage (18) du câble (10) d'un signal continu ayant une tension négative par rapport au sol.

3. Système pour contrôler un câble de communication ayant un noyau, une gaine de protection entourant le noyau, le système comportant un générateur de signal de ligne à tension continue fixe pour l'application du signal de ligne à l'extrémité proximale d'un circuit électrique comportant un conducteur (18) s'étendant le long du câble (10), un chemin de retour et une résistance de terminaison (16) reliant électriquement le conducteur (18) au chemin de retour (18) à l'extrémité distale du circuit électrique pour permettre le contrôle du changement du courant de signal de ligne, de sorte qu'un accroissement du courant du signal de ligne indique une pénétration d'humidité dans le câble (10) constituant un chemin conducteur, caractérisé en ce que le conducteur comporte une couche de blindage métallique (18) du câble de sorte qu'une diminution du courant de signal de ligne est contrôlée pour indiquer un accroissement de la résistance de la couche de blindage et par conséquent un endommagement de la couche de blindage, et en ce que le chemin de retour est un chemin de retour par le sol.

4. Système selon la revendication 3, caractérisé en ce que les moyens de génération de signal comportent des moyens pour appliquer un signal de courant continu à la couche de blindage (18) du câble (10), avec une tension négative par rapport au sol.
